Europäisches Patentamt
European Patent Office
Office européen des brevets

(19)

(11) Publication number: **0 287 722 A1**

(12) # EUROPEAN PATENT APPLICATION

(21) Application number: 87303537.2

(51) Int. Cl.$^4$: **B23K 26/00 , B23K 9/235**

(22) Date of filing: 22.04.87

Amended claims in accordance with Rule 86 (2) EPC.

(43) Date of publication of application: **26.10.88 Bulletin 88/43**

(84) Designated Contracting States: **DE FR GB IT NL**

(71) Applicant: **FUJITSU LIMITED**
1015, Kamikodanaka Nakahara-ku
Kawasaki-shi Kanagawa 211(JP)

(72) Inventor: **Iikawa, Tsutomu**
4-1-602 Shibokuhon-cho 5-chome
Miyamae-ku
Kawasaki-shi Kanagawa 213(JP)
Inventor: **Sakai, Takeaki**
6 Tsukimino 4-chome
Yamato-shi Kanagawa 242(JP)
Inventor: **Kawamura, Isao**
1622 Sugeta-cho Kanagawa-ku
Yokahama-shi Kanagawa 221(JP)
Inventor: **Natori, Katsuhide**
3016-1-1112, Nagatsuta-cho
Midori-ku, Yokohama-shi, Kanagawa 227(JP)
Inventor: **Nagai, Takeshi**
11-8 Kakinokidai Midori-ku
Yokohama-shi Kanagawa 227(JP)
Inventor: **Okamoto, Shigeki**
15-3 Suenaga Takatsu-ku
Kawasaki-shi Kanagawa 213(JP)

(74) Representative: **Rackham, Stephen Neil et al**
GILL JENNINGS & EVERY 53-64 Chancery Lane
London WC2A 1HN(GB)

(54) **Process for laser welding of aluminium based elements.**

(57) A process for laser welding a cover (1) and a casing (2), each made of aluminium or an aluminium based alloy, via a plated nickel layer to form a package for electronic devices, comprising the steps of: boring holes in the sides of the casing (2), thereby providing holes through which input/output (3) and source (4) terminals can be inserted and be soldered hermetically to the casing; plating a nickel layer (5) on the surface of the casing (2); mounting electronic devices in the casing and forming necessary connections between the devices and the terminals; and, welding the cover (1) and the casing (2) together by pulsed YAG laser beam, thereby sealing the cover and the casing hermetically and forming a weld zone of nickel. Preferably the weld zone contains between 1.5 and 10% of nickel by weight and preferably a layer of between 2.5 and 10 μm of nickel is deposited on the surface of the casing (2).

Fig.4

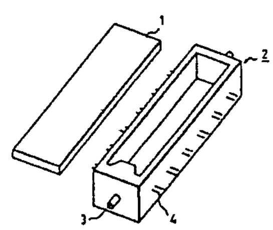


COVER AND CASING

EP 0 287 722 A1

# PROCESS FOR LASER WELDING OF ALUMINIUM BASED ELEMENTS

The present invention relates to an assembly of welded aluminium based elements, particularly a process for making a package for a microwave amplifier.

It is well known that thermal deterioration of elements must be avoided when sealing a package for integrated circuit devices (IC's). Although a stainless steel cover and casing have been used for producing such a package, steel is not only heavy but also exhibits a relatively low thermal conductivity.

This low thermal conductivity causes a deterioration in the performance of IC's mounted in the package because of its low heat dissipation property, particularly in a package for high output amplifiers.

On the other hand, aluminium or an aluminium alloy is lighter and exhibits a desirable malleability and excellent thermal conductivity, and therefore, aluminium or an aluminium alloy is more suitable for producing a package for IC's. Nevertheless, where the aluminium or aluminium alloy elements must be bonded together to produce such a package, this cannot be achieved by brazing, because this method makes it necessary to subject the whole package including the IC's to a high temperature.

Local heating of the package such as occurs during laser welding may be applied when bonding aluminium elements, but aluminium cools rapidly during laser welding because of its high thermal conductivity and the weld zone tends to crack, which leads to a non-airtight sealing of the package. Furthermore, aluminium has a high reflectivity and so tends to reject rather than absorb a laser beam. Therefore, it is impossible to fuse a thick aluminium layer by using a continuous oscillating yttrium-aluminium garnet (YAG) laser which has a relatively low output in the order of several hundred watts, and a $CO_2$ laser. Such cracking may also occur when welding an aluminium based alloy, such as a corrosion resistant aluminium magnesium alloy.

Steve Bolin et al disclose, on page 26 of an article Laser Welding, Cutting and Drilling, Part 2, Assembly Engineering, July 1980, that one successful solution to this problem was to alter the composition of the weld joint by adding a filler metal - specifically type 4047 aluminium alloy (same as 718 braze alloy). The 12% silicon content of this material prevented the occurrence of cracks in a welded zone by increasing the high temperature strength of the metal.

According to this invention, a process for laser welding a cover and a casing, each made of aluminium or an aluminium based alloy, with a nickel intermediate layer to form a package of electronic devices comprises the steps of:

boring holes in sides of the casing, thereby providing holes through which input/output and source terminals can be inserted and be soldered hermetically to the casing;

plating a nickel layer on the surface of the casing;

mounting electronic devices in the casing and forming connections between the devices and the terminals; and

welding the cover and the casing together to seal the cover and the casing hermetically using a pulsed YAG laser beam, thereby forming a weld zone containing 1.5 to 10.0% of nickel by weight.

Using the present invention it is possible to provide a process for the airtight welding of aluminium or aluminium based elements by means of a laser beam so that a package for electronic devices can be formed.

A particular embodiment of a process in accordance with this invention will now be described with reference to the accompanying drawings, in which:-

Figure 1 is a graph showing the relationship between the thickness of nickel plating and leakage;

Figure 2 is a graph showing the relationship between the thickness of nickel plating and the tensile strength;

Figure 3 is a graph showing the relationship between the amount of nickel in the weld zone and the tensile strength;

Figure 4 is a perspective view of a package for electronic devices; and,

Figure 5 is a sectional view of the casing shown in Figure 4.

The cover and casing may be formed by casting or by cutting of essentially pure aluminium or a cast aluminium based alloy, or a corrosion resistant aluminium based alloy or other aluminium based alloy. A pure aluminium may be, e.g. A 1100 as defined in Japanese Industrial Standard (JIS) H 4000. A cast aluminium based alloy may be, e.g. AC4A alloy, which contains, in percentage by weight < 0.2 Cu, 8.0 to 10.0 Si, 0.2 to 0.8 Mg, < 0.2 Zn, < 0.7 Fe, 0.3 to 0.8 Mn, < 0.2 Ti. A corrosion resistant aluminium based alloy may be, e.g., A 5052 alloy which contains, in percentage by weight, < 0.45 (Si + Fe), < 0.10 Cu, < 0.10 Mn, 2.2 to 2.8 Mg, 0.15 to 0.35 Cr, < 0.10 Zn. Both of these alloys are defined also in JIS H 4000.

EXAMPLE 1

A cover 1 and a casing 2 having a side thickness of 2.5 mm were produced of A 1100 pure aluminium. Two holes for inserting input/output terminals 3 were bored in the end side surfaces of the casing, and twenty four holes for inserting source terminals 4 were bored in the longitudinal side surface of the casing, as shown in Figure 4. Then, the casing 2 was chemically plated by means of a plating solution which comprised nickel sulfate 350 g/l, nickel chloride 50 g/l, and boron sulfate 10 g/l, as shown in Figure 5. Gallium arsenic FET devices were mounted in the recess of the casing, and the input/output terminals 3 and source terminals 4 were inserted in the side wall of the casing and were soldered to the casing hermetically. The nickel layer 5 exhibited a good underplating for soldering. The necessary connections were accomplished between the electronic devices and the terminals.

The cover 1 and casing 2 were butted together via plated nickel layer 5. The laser welding was carried out in nitrogen with a welding speed of 4 mm/s by a 0.3 mm laser beam with an average output of 200 W, a pulse width of 4 ms, and a pulse rate of 15 p/s.

A series of leakage tests were carried out by means of a helium leak detector (Veeco Ltd). High airtightness was obtained when the thickness of the plated nickel on the surface of the casing, was in the range of 2 to 10 µm, as shown in Figure 1.

EXAMPLE 2

Industrial pure grade aluminium and aluminium magnesium alloy plates were plated on each side with a nickel layer having a thickness of 1.2, 2.4, 4.0, 5.0, 8.5 or 10.9 µm and these nickel plated plates were welded by means of a pulsed YAG laser.

A series of tests of tensile strength were carried out by means of a tester (Instron Ltd., type 1195), with a drawing speed of 0.5 mm/min. As shown in Figure 2, when the thickness of the plated nickel was in the range of 2.5 to 10 µm, the weld zone exhibits a high tensile strength.

As explained with reference to Figure 1, a desirable hermetical sealing was obtained when the thickness of the plated nickel was in the range of 2 to 10 µm, which corresponds nearly to the thickness of 2.5 to 10 µm shown in Figure 2. While, a desirable tensile strength was obtained when the weld zone contained 1.5 to 10% by weight of nickel as shown in Figure 3. These packages exhibited a desirable reliability in the test of MIL-STD-202E Reliability Test Method.

## Claims

1. A process for laser welding a cover and a casing, each made of aluminium or an aluminium based alloy, with a nickel intermediate layer to form a package of electronic devices the process comprising the steps of:

boring holes in sides of the casing, thereby providing holes through which input/output and source terminals can be inserted and be soldered hermetically to the casing;

plating a nickel layer on the surface of the casing;

mounting electronic devices in the casing and forming connections between the devices and the terminals; and

welding the cover and the casing together to seal the cover and the casing hermetically using a pulsed YAG laser beam, thereby forming a weld zone containing 1.5 to 10.0% of nickel by weight.

2. A process according to claim 1, wherein the thickness of the plated nickel layer is 2.5 to 10 µm.

3. A process for welding an aluminium or aluminium based alloy cover and casing together to form a package for electronic devices comprising:

forming the casing with input/output and source terminals hermetically sealed through its side walls;

plating a nickel layer having a thickness between 2.5 and 10µm on the surface of the casing and/or the cover;

mounting electronic devices in the casing and forming electrical connections between the devices and the terminals; and,

welding the cover and the casing together to hermetically seal them using a pulsed YAG laser beam.

Amended claims in accordance with Rule 86(2) EPC.

1. A process for laser welding a cover and a casing with side walls, each made of aluminium or an aluminium based alloy, via a nickel layer plated on to it to form a package for electronic devices the process comprising the steps of:

boring holes in the side walls of the casing;

plating a nickel layer on the surface of the casing;

inserting input/output and source terminals through the holes bored in the side walls of the casing;

soldering the input/output and source terminals into the holes bored in the side walls of the casing;

mounting electronic devices in the casing and forming connections between the devices and the terminals; and

welding the cover and the casing together by using a pulsed YAG laser beam, thereby forming a weld zone containing 1.5 to 10.0% of nickel by weight and sealing the cover to the casing hermetically.

2. A process according to claim 1, wherein the thickness of the plated nickel layer is 2.5 to 10 µm.

3. A process for welding an aluminium or aluminium based alloy cover and casing together to form a package for electronic devices comprising:

forming the casing with input/output and source terminals hermetically sealed through its side walls;

plating a nickel layer having a thickness between 2.5 and 10µm on the surface of the casing and/or the cover;

mounting electronic devices in the casing and forming electrical connections between the devices and the terminals; and,

welding the cover and the casing together to hermetically seal them using a pulsed YAG laser beam.

Fig.1

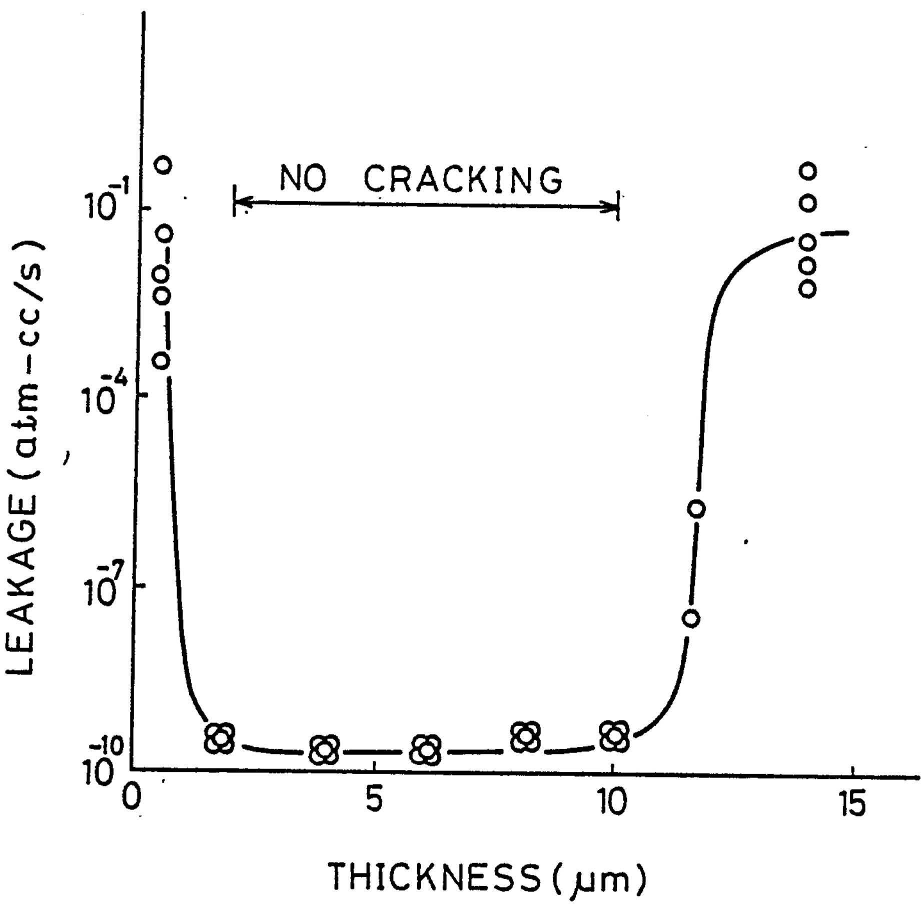
NO CRACKING
LEAKAGE (atm-cc/s)
10^-1
10^-4
10^-7
10^-10
0
5
10
15
THICKNESS (μm)

Fig. 2

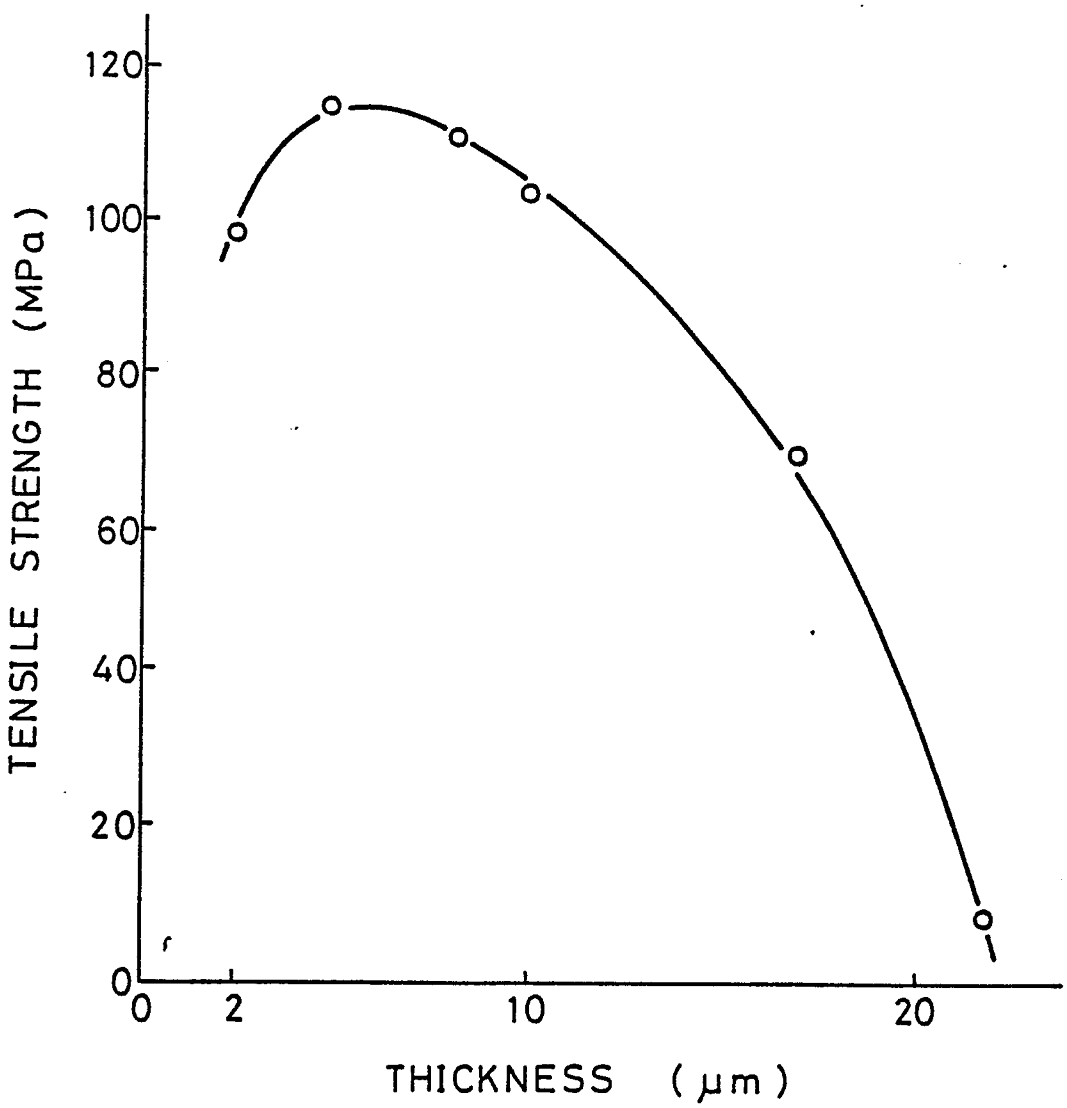

120
100
80
60
40
20
0
TENSILE STRENGTH (MPa)
0
2
10
20
THICKNESS (μm)

Fig. 3

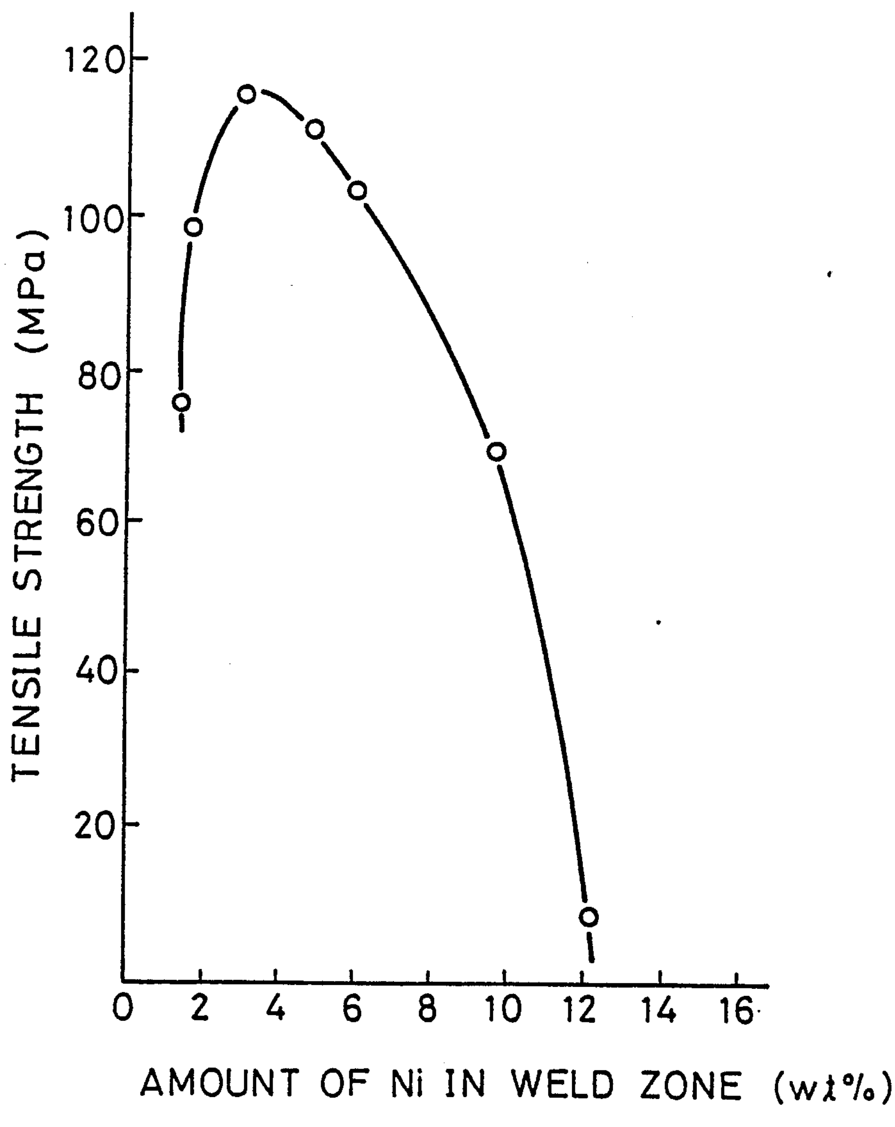
TENSILE STRENGTH (MPa)
120
100
80
60
40
20
0
2
4
6
8
10
12
14
16
AMOUNT OF Ni IN WELD ZONE (wt%)

Fig.4

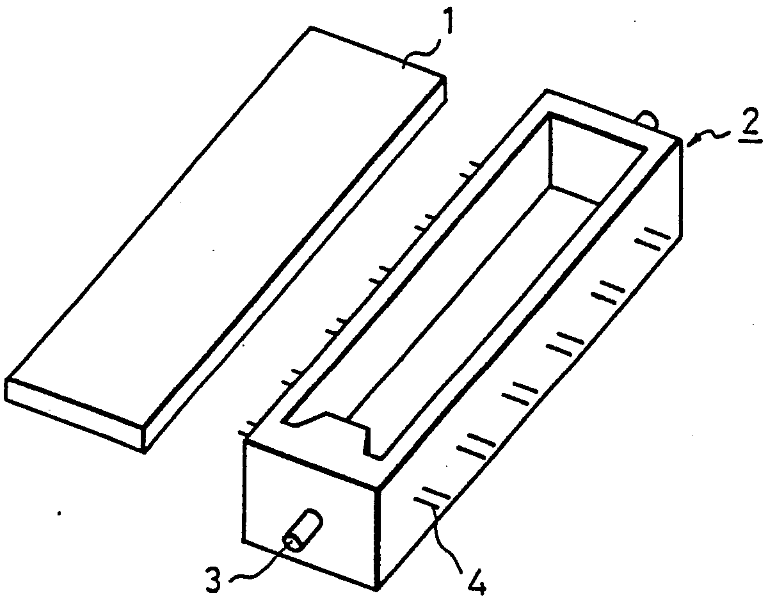


COVER AND CASING

Fig.5

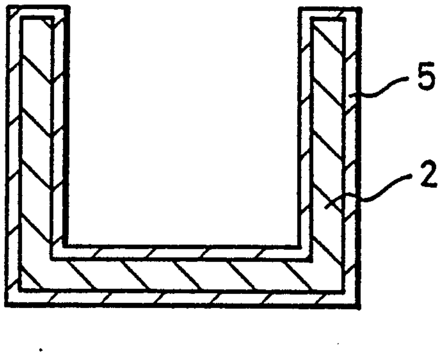

European Patent Office

# EUROPEAN SEARCH REPORT

Application Number

EP 87 30 3537

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | PATENT ABSTRACTS OF JAPAN, vol. 10, no. 151 (M-483)[2208], 31st May 1986; & JP - A - 61 3694 (FUJITSU K.K.) 09-01-1986 | 1,3 | B 23 K 26/00<br>B 23 K 9/235 |
| Y | US-A-4 521 668 (T.A. OSIAL et al.)<br>* complete document * | 1,3 | |
| A | US-A-4 270 986 (G.W. SMITH)<br>* claims * | 2 | |

TECHNICAL FIELDS SEARCHED (Int. Cl.4)

B 23 K 1/00
B 23 K 9/00
B 23 K 26/00

The present search report has been drawn up for all claims

| Place of search | Date of completion of the search | Examiner |
|---|---|---|
| BERLIN | 08-12-1987 | WUNDERLICH J E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)